# FASCICULE DE BREVET EUROPEEN

(11) **EP 3 750 199 B1**
(45) Date de publication et mention de la délivrance du brevet: **17.08.2022**
(21) Numéro de dépôt: 19718799.0
(22) Date de dépôt: 26.03.2019
(51) Int. Cl.: H01L 45/00, H01L 27/24

(54) **MEMOIRE RESISTIVE 3D**
DREIDIMENSIONALER WIDERSTANDSSPEICHER
RESISTIVE 3D MEMORY

(30) Priorité: 27.03.2018 FR 1852657
(43) Date de publication de la demande: 16.12.2020
(73) Titulaire: Commissariat à l'énergie atomique et aux énergies alternatives, 75015 Paris (FR)
(72) Inventeur: ANDRIEU, François, 38054 Grenoble Cedex 09 (FR)
(74) Mandataire: Brevalex
(86) Numéro de dépôt international: PCT/FR2019/050677
(87) Numéro de publication internationale: WO 2019/186045

(56) Documents cités:
- US-A1- 2009 218 558
- US-A1- 2013 070 506
- US-A1- 2013 288 391
- US-A1- 2014 005 438
- US-A1- 2015 249 053
- US-A1- 2017 092 541

## Description

### DOMAINE TECHNIQUE ET ART ANTÉRIEUR

La présente invention se rapporte au domaine de la microélectronique et des mémoires et en particulier celui des mémoires résistives non-volatiles RRAM ou ReRAM (pour « Resistive random-access memory »).

Les mémoires résistives ont pour principe commun de fonctionnement que leurs changements d'états sont dus à des changements de résistivité d'un matériau disposé entre deux électrodes.

Il existe plusieurs types de mémoires résistives parmi lesquelles figurent les PCRAM (pour « Phase-change random access memory »), les CBRAM (pour « conductive-bridging RAM »), les OxRAM.

Dans une OxRAM, le matériau agencé entre les électrodes comprend un oxyde diélectrique, normalement isolant et qui peut être rendu conducteur par création de filaments ou d'un chemin de conduction dans ce matériau après l'application d'une tension ou d'un courant suffisant.

On cherche continuellement à augmenter la densité des dispositifs mémoires.

Pour cela, des dispositifs dans lesquelles des cellules mémoires sont réparties sur plusieurs niveaux superposés, sont apparus.

Dans le domaine des mémoires résistives, le document: "Four Layer 3D Vertical RRAM Integrated with FinFET as Versatile Computing unit for Brain-Inspired Cognitive Information Processing", de Li et al., Symposium on VLSI Technology Digest of Technical Papers 2016, présente un dispositif avec des cellules mémoires résistives réalisées à partir d'un empilement de couches et qui sont réparties sur plusieurs niveaux de cellules superposées. Chaque cellule de ce dispositif est formée d'un élément mémoire ayant une électrode de TiN, un diélectrique de type HfOx et une autre électrode formée d'un empilement de TiN et de Ti. La lecture ou l'écriture d'une information contenue dans l'élément mémoire se fait par l'intermédiaire d'un transistor dit « de sélection ». Dans ce dispositif, un même transistor de sélection est associé à un ensemble de quatre éléments mémoires superposés et sert ainsi à adresser ces 4 éléments. Avec un tel agencement, des éléments mémoires superposés sont associés au même transistor de sélection et n'ont pas un adressage indépendant.

Par ailleurs, le transistor de sélection est formé dans une couche semi-conductrice superficielle d'un substrat et occupe une place dans cette couche semi-conductrice que l'on peut souhaiter dédier à d'autre(s) fonction(s). Des structures connues sont divulguées par US 2017 / 0092541 A1, US 2013 / 0070506 A1, US 2015 / 0249053 A1, US 2014 / 0054538 A1, US 2009 / 0218558 A1 et US 2013 / 0288391 A1.

Il se pose le problème de réaliser un nouveau dispositif à cellules mémoire résistives et qui soit amélioré vis-à-vis d'inconvénients mentionnés ci-dessus.

### EXPOSÉ DE L'INVENTION

L'invention est définie par l'objet des revendications indépendantes. Les revendications dépendantes définissent des modifications avantageuses.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1B, servent à illustrer un exemple d'agencement d'un dispositif mémoire 3D à cellules mémoires résistives réparties sur plusieurs niveaux et formées chacune d'un élément mémoire en série avec un transistor de commande ;
- la figure 2, donne un exemple de schéma électrique équivalent d'une cellule mémoire résistive susceptible d'être intégrée dans un dispositif mémoire 3D tel que mis en œuvre suivant l'invention ;

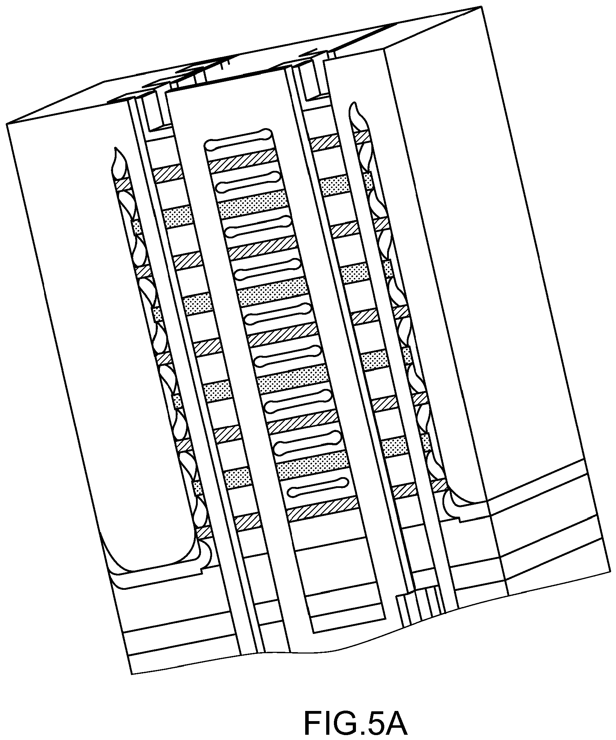

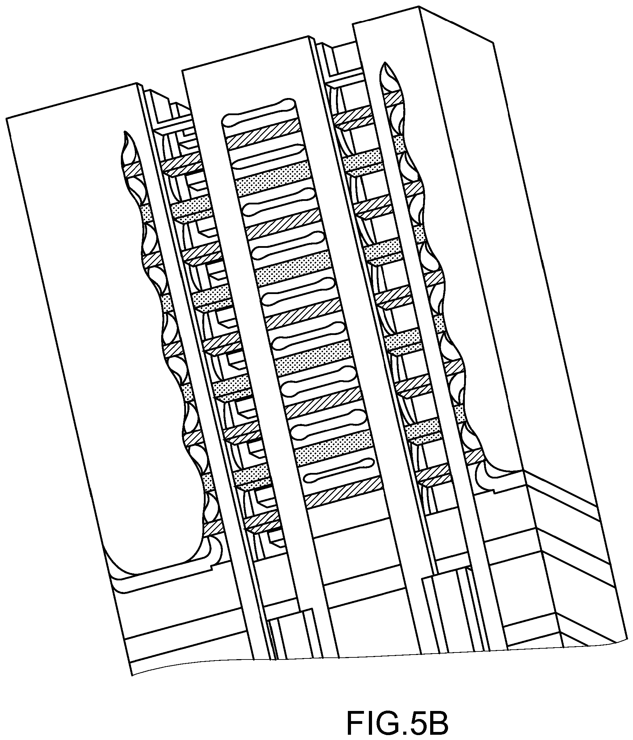

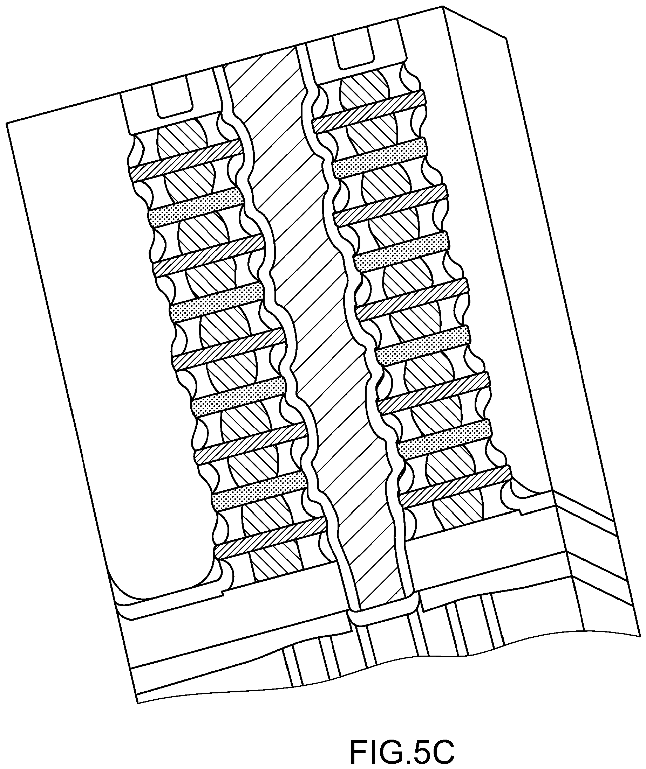

- les figures 3A-3J, 4, 5A-5C illustrent un exemple de procédé de fabrication d'un dispositif mémoire 3D à cellules mémoires résistives superposées ;
- la figure 6 illustre un exemple d'agencement particulier de cellules mémoires résistives dans lequel un même transistor de commande est associé à deux éléments mémoires distincts ;
- la figure 7 illustre un exemple de réalisation d'un dispositif ayant un agencement du type de celui de la figure 6 ;
- la figure 8 illustre un exemple de dispositif mémoire adressable par le contenu et doté de cellules résistives suivant un agencement tel que mis en œuvre suivant un mode de réalisation de la présente invention ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « sur », « au-dessus », « verticale », « horizontale », « latérale », « supérieure », « inférieure », s'appliquent en considérant que la structure est orientée de la façon illustrée dans les figures.

### EXPOSÉ DÉTAILLÉ DE MODES DE RÉALISATION PARTICULIERS

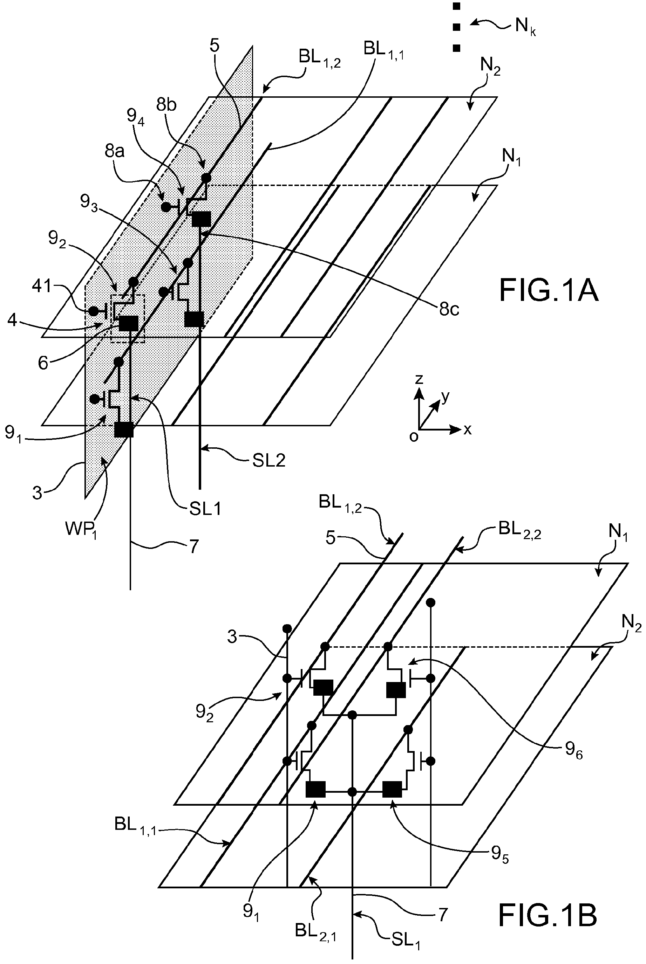

Un exemple de dispositif microélectronique de mémoire à 3 dimensions ou « 3D » tel que mis en œuvre suivant un mode de réalisation de la présente invention, va à présent être décrit en liaison avec les figures 1A-1B.

Le dispositif mémoire est formé de cellules mémoires 9₁,...9₄, 9₆,...9ₙ résistives agencées sur un support (non représenté sur les figures 1A-1B), tel qu'un substrat semi-conducteur ou un substrat de type semi-conducteur sur isolant, avantageusement un substrat sur lequel un ou plusieurs niveau(x) de composants et éventuellement un ou plusieurs niveau(x) d'interconnexions ont également été formés, les composants (et le cas échéant les interconnexions) étant dans ce cas disposé(e)s sous l'ensemble desdites cellules.

Les cellules mémoires résistives sont réparties, sur plusieurs niveaux Ni, N₂,..., Nₖ ou étages superposés, en colonnes verticales de cellules mémoires disposées sur ce support, chaque étage ou niveau de cellules comportant une ou plusieurs rangées horizontales d'une ou plusieurs cellules mémoires résistives.

Dans la vue en perspective partielle de la figure 1A, les rangées horizontales de cellules résistives d'un premier niveau N₁ et d'un deuxième niveau N₂ sont réparties selon une direction parallèle au plan [O ; x ; y ] et en particulier à l'axe y d'un repère orthogonal [O ; x; y ; z]. Les colonnes verticales de cellules correspondent à des superpositions de cellules dans une direction parallèle à l'axe z de ce même repère.

Chaque cellule mémoire 9₁,..., 9₄ est dotée d'au moins un élément mémoire 6 à résistance modulable formé d'une zone de matériau résistif de résistivité variable agencé entre des électrodes. L'élément mémoire 6 peut être de type OxRAM lorsque le matériau disposé entre les électrodes comprend un oxyde diélectrique.

Dans le cas d'un élément mémoire 6 de type PCRAM, on peut avoir une des deux électrodes qui est métallique mais résistive, par exemple en TiN et prévue pour permettre de chauffer par effet joule un matériau chalcogénure disposé entre les électrodes, par exemple du GeSbTe.

L'élément mémoire 6 est associé, et dans cet exemple relié en série, à au moins un transistor 4 dit « de commande ». En fonction de la manière dont ce transistor de commande est polarisé on peut moduler un courant que ce transistor de commande est susceptible de délivrer à l'élément mémoire 6 et pouvoir ainsi pouvoir modifier un état de conduction de l'élément mémoire 6 et par conséquent modifier une information stockée dans la cellule mémoire correspondante contenant cet élément mémoire 6. De la même manière on peut également réaliser un accès en lecture de l'information stockée, et permettre de générer un signal électrique que l'on récupère à une borne l'élément mémoire 6, le niveau de ce signal étant alors représentatif d'une information logique stockée dans l'élément mémoire 6.

Le transistor de commande 4 d'une cellule a typiquement au moins sa région de canal formée dans une couche semi-conductrice appartenant à une superposition de couches semi-conductrices (non représentées sur les figures 1A-1B) agencées sur le support. Les couches semi-conductrices de cette superposition sont de préférence isolées entre elles par le biais de couches isolantes intermédiaires afin de pouvoir former une isolation électrique entre les différents niveaux ou étages de cellules. Chaque couche isolante intermédiaire peut être ainsi disposée entre deux couches semi-conductrices afin de pouvoir former une isolation entre deux niveaux adjacents ou voisins.

Chaque cellule 9₁,...9₄, est dans cet exemple de réalisation dotée de trois électrodes de contrôle 8a, 8b, 8c correspondant respectivement à une électrode de grille du transistor de commande 4, une électrode de source ou de drain du transistor de commande 4 et une électrode de l'élément mémoire 6, l'autre électrode de cet élément étant connectée au drain ou à la source du transistor de commande 4.

La première électrode de contrôle 8a autrement dit la grille du transistor de commande 4 est reliée à une zone de conductrice 3 que l'on appelle dans cet exemple « plan de mot » (WPₓ).

La sélection d'une cellule mémoire donnée afin de réaliser en particulier une opération de lecture ou d'écriture sur cette cellule, se fait notamment par l'intermédiaire d'un signal appliqué sur un plan de mot auquel la grille du transistor de commande de cette cellule est reliée ou formant la grille du transistor de commande de cette cellule.

Typiquement, les transistors de commande 4 d'une même colonne verticale de cellules partagent un même plan de mot et peuvent avoir ainsi une électrode de grille commune ou des électrodes de grilles connectées entre elles et à un même plan de mot.

Dans l'exemple de réalisation particulier illustré sur la figure 1A, par souci de simplification, seuls deux niveaux N₁, N₂ de cellules 9₁, 9₂, 9₃, 9₄, et un seul plan de mot sont représentés. On prévoit un agencement avec un premier plan de mot WP₁ associé à plusieurs colonnes verticales juxtaposées de cellules 9₁, 9₂, et 9₃, 9₄. Les transistors de commande 4 respectifs de ces cellules 9₁, 9₂, 9₃, 9₄ ont ainsi une électrode de grille commune ou des électrodes de grilles respectives connectées entre elles et à un même premier plan de mot WP₁. La mémoire comporte typiquement d'autres plans de mots (non représentés sur la figure 1A) distincts et qui peuvent être commandés électriquement indépendamment les uns des autres. Chaque plan de mot est associé à un groupe de cellules formé d'une superposition de rangées horizontales de cellules ou d'une juxtaposition de colonnes verticales. Dans l'exemple illustré sur la figure 1A, la superposition ou la juxtaposition formant un groupe de cellules reliées à un même plan de mot WP₁ s'étend sensiblement parallèlement au plan [O ;y ;z].

On peut en variante (non représentée) de l'exemple illustré prévoir un agencement avec un plan de mot par colonne verticale de cellules.

La deuxième électrode 8b des cellules d'une même rangée horizontale de cellules d'un même niveau est typiquement reliée ou connectée à une même ligne conductrice 5 de polarisation horizontale parmi une pluralité de lignes de polarisation horizontales que l'on appellera ici « lignes de bits » (BL_{x,z}). Les lignes conductrices 5 de polarisation horizontales s'étendent parallèlement au plan principal du support et dans cet exemple parallèlement au plan [O ;x ;y].

Ainsi, dans l'exemple illustré sur la figure 1A, les cellules 9₁, 9₃ d'une même rangée horizontale du premier niveau N₁ sont connectées à une première ligne de bit BL_{1,1}, tandis que les cellules 9₁, 9₂ d'une même rangée horizontale du deuxième niveau N₂ sont connectées à une deuxième ligne de bit BL_{1,2}, distincte de la première ligne de bit BL_{1,1} et qui peut être commandée électriquement indépendamment de la première ligne de bit BL_{1,1}.

Les troisièmes électrodes 8c respectives de cellules d'une colonne verticale de cellules appartenant à des niveaux différents sont typiquement reliées ou connectées à une même ligne conductrice de polarisation verticale 7 parmi une pluralité de lignes conductrices de polarisation verticales que l'on appelle ici « lignes de source » (SL_{y}).

Ainsi, dans l'exemple illustré, la première cellule 9₁, et la deuxième cellule 9₂, sont connectées à une même première ligne de source SL₁, tandis que la troisième cellule 9₃ et la quatrième cellule 9₄ sont connectées à une même deuxième ligne de source SL₂, distincte de la première ligne de source SL₁ et qui peut être commandée électriquement indépendamment de la première ligne de source SL₁.

Un agencement particulier prévoit des cellules d'un même niveau connectées à une même ligne de source également partagée par d'autres cellules de niveaux différents. Ainsi, sur la vue partielle de la figure 1B, la première cellule 9₁ et une cinquième cellule 9₅ appartenant toutes les deux au premier niveau N₁ et respectivement à une première rangée horizontale et à une deuxième rangée horizontale de cellules, sont connectées à la même ligne de source SL₁. La deuxième cellule 9₂, et une sixième cellule 9₆ située sur une même colonne verticale que la cinquième cellule 9₅, sont connectées à cette même ligne de source SL₁.

Le nombre de niveaux, de rangées et de cellules par rangée peut être différent et en particulier bien plus important que celui de l'exemple de réalisation illustré.

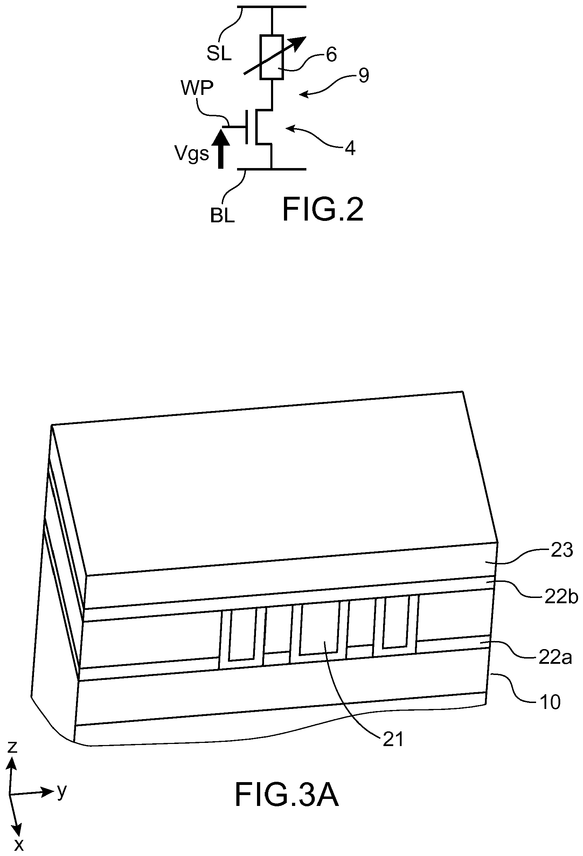

La figure 2 donne un schéma électrique équivalent d'une cellule 9 mémoire résistive susceptible d'être intégrée à un dispositif mémoire 3D à étages superposés tel que mis en œuvre suivant un mode de réalisation de la présente invention.

Une opération d'écriture sur cette cellule 9 peut être mise en œuvre par exemple en appliquant, sur une ligne de source SL à laquelle cette cellule 9 est connectée, un potentiel VSL=Vset, tel que Vset > 0V et en rendant son transistor de commande 4 passant, en appliquant un potentiel VWL > 0V sur le plan de mot WP connecté à la grille de ce transistor et en appliquant un potentiel VBL égal à un potentiel de masse GND sur la ligne de bit BL connectée à la source du transistor de commande 4.

Une opération d'effacement sur cette cellule 9 peut être mise en œuvre par exemple en mettant la ligne de source SL au potentiel de masse VSL=GND et en appliquant un potentiel VBL=Vreset > 0V sur la ligne de bit BL. Pour réaliser l'effacement, le plan de mot WP peut être quant à lui activé en appliquant un potentiel VWL>0V.

Une opération de lecture sur la cellule 9 peut être réalisée par exemple en mettant la ligne de source SL à un potentiel VSL=Vread> 0V et en appliquant un potentiel VBL=GND. Lors d'une lecture de la cellule 9, le plan de mot WP est alors également activé en appliquant un potentiel VWL>0V.

On prévoit une polarisation du transistor de commande 4 de sorte que le courant qu'il délivre est plus faible lors des opérations de lecture que lors des opérations d'écriture. Dans cet exemple, on prévoit donc Vset>Vread.

Pour une cellule non sélectionnée et reliée à un plan de mot qui n'est relié à aucune cellule sélectionnée, et donc sur lesquelles on ne fait aucune des opérations précitées d'écriture, effacement, lecture, on prévoit de ne pas activer ce plan de mot, en appliquant ainsi typiquement un potentiel VWL=0 ou en laissant le plan de mot à la masse (GND).

Pour une cellule non-sélectionnée mais qui est reliée à un plan de mot lui-même relié à au moins une cellule sélectionnée (sur laquelle réalise une opération d'écriture ou d'effacement ou de lecture) on prévoit d'activer ce plan de mot en lui appliquant ainsi un potentiel VWL≠0V. Les potentiels respectifs de la ligne de source et de la ligne de bit aux extrémités de la cellule sont typiquement égaux (VSL=VBL) de sorte à empêcher un courant de circuler à travers la cellule.

Pour une cellule non sélectionnée mais qui partage une ligne de source avec une ou plusieurs cellules sélectionnées, on peut avoir des potentiels respectifs de la ligne de source et de ligne de bit aux extrémités de la cellule différents (VSL≠VBL) le plan de mot de cette cellule n'étant pas activé (VWL=OV).

Un exemple de procédé de réalisation d'un dispositif de mémoire résistive 3D va à présent être donné.

Une structure de départ possible du procédé est un support 10 de type substrat massif (« bulk » selon la terminologie anglo-saxonne) ou bien sous forme d'un substrat de type semi-conducteur sur isolant, par exemple de type SOI (pour « Silicon On Insulator » ou « silicium sur isolant »).

Avantageusement, on peut partir d'un support formé d'un substrat sur lequel au moins un étage de transistors a déjà réalisé. Les transistors ont alors typiquement au moins leur région de canal qui s'étend dans une couche semi-conductrice du substrat.

L'étage de transistors peut être lui-même recouvert d'au moins un étage d'interconnexions. Le procédé de réalisation du dispositif mémoire peut dans ce cas s'intégrer dans une partie de procédé de fabrication d'un dispositif microélectronique communément appelée de « back-end ».

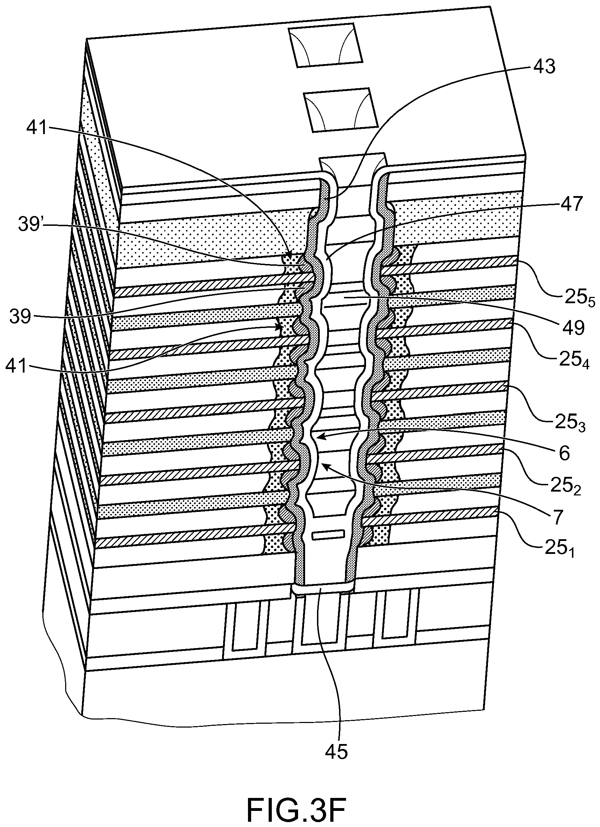

Sur le support 10, on peut prévoir de réaliser une ou plusieurs lignes 21 conductrices horizontales autrement dit qui s'étendent parallèlement au plan principal du support (figure 3A). Par « plan principal » du support on entend un plan passant par le support et qui est parallèle au plan [O ;x ;y] du repère orthogonal [O ;x ;y ;z]. Cette ou ces lignes 21 conductrices horizontales sont appelées lignes « de routage ». Une ligne de routage 21 permet de connecter entre elles plusieurs lignes conductrices de polarisation verticales autrement dit qui ne sont pas parallèles au plan principal et s'étendent typiquement orthogonalement au plan principal du support ou dans une direction parallèle à l'axe z du repère orthogonal [O ;x ;y ;z]. Les lignes 21 de routage sont par exemple en métal tel que du cuivre. Dans ce cas, les lignes 21 de routage peuvent être encapsulées par le biais de couches barrière de diffusion au cuivre. On peut prévoir pour cela de réaliser les lignes 21 de routage entre une première et une deuxième couche diélectrique 22a, 22b barrières de diffusion, par exemple à base de nitrure SiCN.

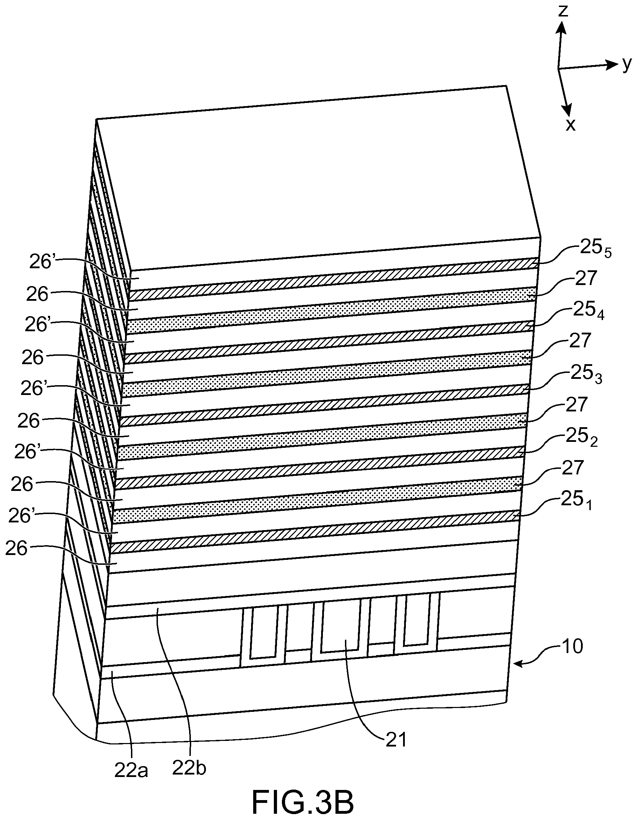

Ensuite (figure 3B), on forme un empilement de couches comprenant une superposition de couches semi-conductrices 25₁, 25₂, 25₃, 25₄, 25₅ à partir desquelles des transistors de commande sont aptes à être formés et dans lesquelles des régions de canal respectives de ces transistors de commande sont en particulier prévues. Les couches semi-conductrices 25₁, .., 25₅ sont par exemple en silicium. Il est également possible en variante de choisir un matériau III/V ou un matériau bidimensionnel de type métal de transition dichalcogéniures tel que par exemple le MOS₂.

Les couches semi-conductrices 25₁, ..., 25₅, peuvent être déposées sous forme amorphe, par exemple par CVD (pour « Chemical Vapor Deposition », c'est à dire « dépôt chimique en phase vapeur ») puis rendues cristallines par le biais de recuit(s) laser. Un recuit de cristallisation peut être après chaque dépôt ou après avoir effectué l'ensemble des dépôts. Avec un tel type de recuit on met en œuvre un échauffement très localisé d'une couche semi-conductrice tout en limitant un échauffement de parties sous-jacentes de l'empilement en cours de réalisation. On réalise l'empilement de couches 25₁,...,25₅ de préférence en limitant le budget thermique vu par le premier niveau Ni, de préférence inférieur à 450°C ou à 550°C afin de ne pas dégrader le support, et en particulier empêcher une diffusion intempestive de dopants dans des couches sous-jacentes ou une dégradation d'éventuelle d'interconnexions ou un changement de phase vers une phase plus résistive de zones siliciurées par exemple en NiSi, déjà fabriquées.

Un dopage *in situ* des couches 25₁,...,25₅, autrement dit effectué lors de leur dépôt, peut être mis en œuvre. On peut effectuer ce type de dopage notamment lorsqu'on prévoit de réaliser des transistors de commande de type sans jonction encore appelés « junctionless ».

Les différents niveaux de couches semi-conductrices 25₁, 25₂, 25₃, 25₄, 25₅ sont isolés entre eux par le biais de couches 27 isolantes intermédiaires, en matériau diélectrique tel que par exemple du nitrure de silicium (SiN).

Pour faciliter la réalisation ultérieure de lignes conductrices de polarisation horizontales et/ou verticales, et permettre de rendre plus aisée la connexion de ces lignes avec les différentes couches semi-conductrices de ladite superposition de couches semi-conductrices 25_{1,.}.., 25₅, on prévoit d'agencer les couches semi-conductrices 25₁, ..., 25₅, entre des couches 26, 26' de matériau sacrificiel. Le matériau sacrificiel peut être un matériau semi-conducteur différent de celui des couches semi-conductrices 25₁, ..., 25₅, et que l'on peut graver sélectivement par rapport au matériau semi-conducteur des couches 25₁, ..., 25₅. Par exemple, on peut prévoir des couches sacrificielles 26, 26' en SiGe lorsque les couches semi-conductrices 25₁, .., 25₅, sont en Si.

L'empilement réalisé peut avoir une épaisseur par exemple de l'ordre de plusieurs centaines de nanomètres. Une fois cet empilement formé, on peut réaliser une ou plusieurs lignes de source, des éléments mémoire, une ou plusieurs lignes de bits ainsi que des grilles et/ou plans de mot des transistors de commande.

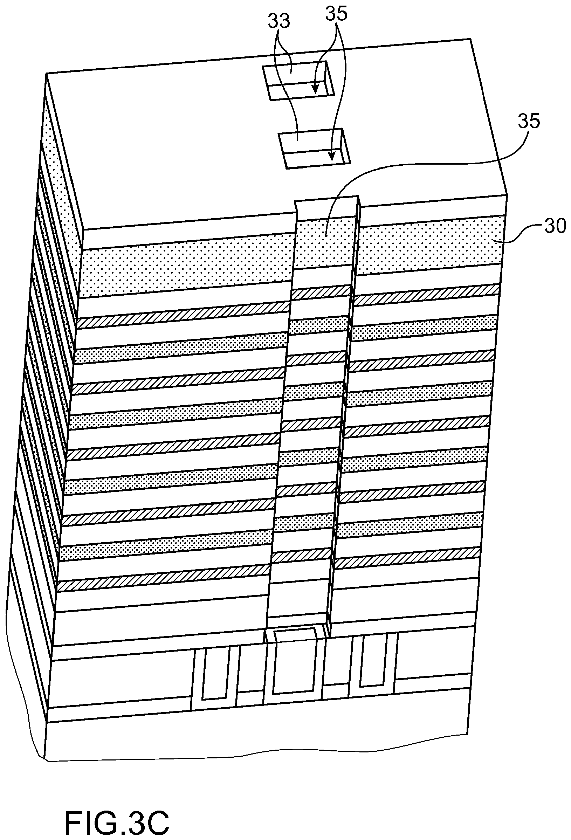

Dans l'exemple illustré sur les figures 3C à 3F, on forme une ou plusieurs lignes conductrices 7 de polarisation verticales, en particulier des lignes de source SL auxquelles des éléments mémoires sont destinés à être connectés.

Pour cela, on effectue un ou plusieurs trous 35 traversant l'empilement de couches (figure 3C). Les trous 35 peuvent être prévus chacun pour accueillir une structure verticale de pilier conducteur. Dans cet exemple de réalisation, une structure de pilier conducteur verticale comporte une colonne d'éléments mémoires résistifs.

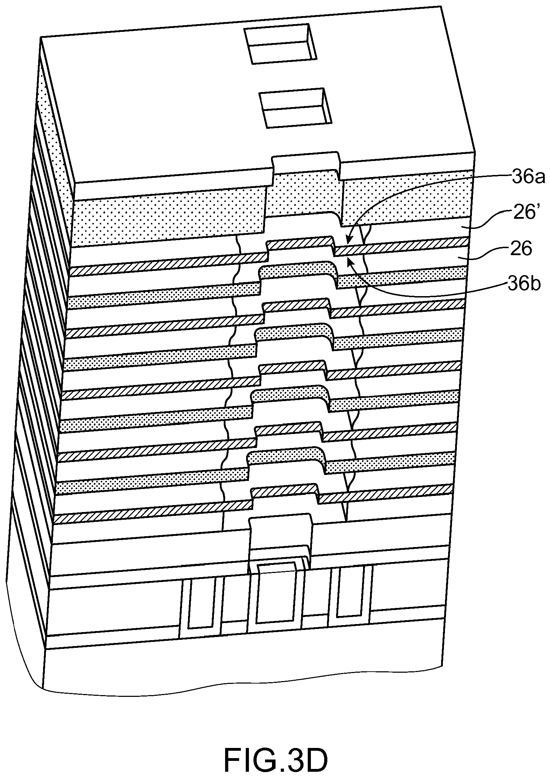

Pour réaliser les trous 35, on forme typiquement un masque dur 31, comprenant par exemple une couche de TiN dans laquelle une ou plusieurs ouvertures 33 sont pratiquées. A travers la ou les ouvertures 33 on grave alors l'empilement. Les trous 35 verticaux sont réalisés de sorte qu'au moins un trou 35 atteigne et dévoile une ligne 21 de routage. Le masque dur 31 peut être mis en œuvre sur une couche de matériau diélectrique 30, par exemple une couche de nitrure recouvrant l'empilement. Pour permettre de dévoiler des zones 36a, 36b, respectivement d'une face supérieure et d'une face inférieure des couches semi-conductrices 25₁, ..., 25₅., on effectue ensuite une gravure sélective isotrope du matériau sacrificiel des couches 26, 26', vis-à-vis de celui des couches semi-conductrices 25₁, ..., 25₅ (figure 3D).

On choisit également de préférence un procédé de gravure sélective vis-à-vis des couches 27 isolantes intermédiaires dans cet exemple en nitrure. Par exemple, lorsque les couches 26, 26'sacrificielles sont en SiGe, et les couches semi-conductrices 25₁, .., 25₅ en Si, cette gravure sélective peut être réalisée à l'aide d'une gravure de type RIE (pour « Reactive Ion Etching ») en chimie CF₄ par exemple ou en chimie par solution de type acide acétique.

La gravure sélective permet de libérer des espaces correspondant à des portions gravées des couches sacrificielles 26, 26' et communicant avec les trous 35.

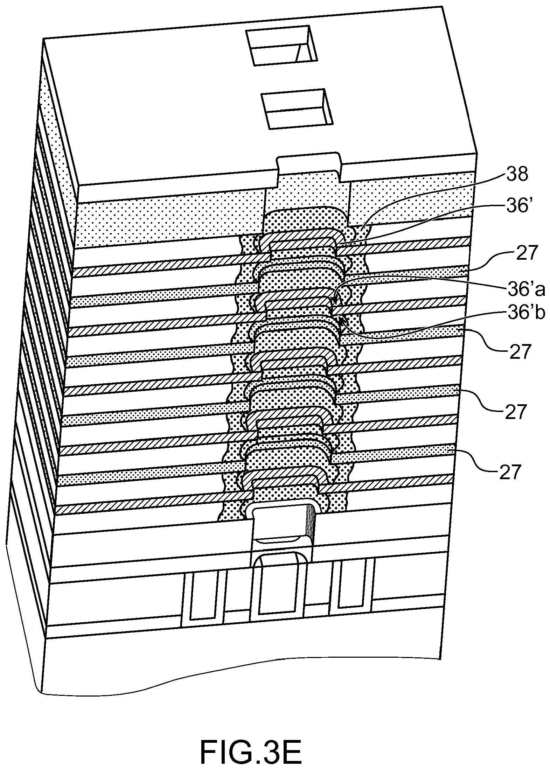

On peut ensuite (figure 3E) prévoir de recouvrir partiellement les zones 36a, 35b dévoilées des couches semi-conductrices 25₁,..., 25₅ par des espaceurs isolants internes 38, par exemple en SiCO, tout en laissant des régions 36'a, 36'b respectivement de la face supérieure et de la face inférieure des couches semi-conductrices 25₁, ..., 25₅ dépasser.

On forme ensuite sur ces régions 36'a, 36'b, une première électrode 41 pour les éléments mémoire résistifs. Cette première électrode 41 peut être réalisée par métallisation et/ou par formation d'un alliage de semi-conducteur et de métal, en particulier un siliciure, typiquement réalisé par dépôt de métal, par exemple du Ni ou du Ti ou du Co, suivi d'un recuit par exemple réalisé dans un four ou bien à l'aide d'un laser. Par exemple, la première électrode 41 peut comprendre une couche de siliciure de type NiSi, un tel siliciure ayant pour avantage de pouvoir être réalisé à une température inférieure à 550°C. Un autre exemple de réalisation prévoit une première électrode 41 en TiN.

La première électrode 41 réalisée peut être ainsi formée de régions 39, 39' de métal ou d'alliage de métal et de semi-conducteur réparties respectivement sur une région 36'a de la face supérieure des couches semi-conductrices 25₁, ..., 25₅, et sur une région 36'b de la face inférieure de ces mêmes couches semi-conductrices 25₁, ..., 25₅.

Dans cet exemple de réalisation, le matériau de la première électrode 41 ne forme pas une zone continue le long de la paroi des trous 35, mais est intercalé entre les couches semi-conductrices 25₁, ..., 25₅ et les couches isolantes 27. Ainsi, les premières électrodes 41 respectives des différents éléments mémoire résistifs sont isolées entre elles notamment par le biais des couches 27 isolantes.

Puis, on dépose au moins une couche de matériau 43 résistif tapissant les parois des trous 35 afin de réaliser le matériau inter-électrodes des éléments mémoires. Ce matériau 43 inter-électrodes peut être un matériau diélectrique et en particulier un oxyde diélectrique tel que du HfO₂ ou un oxyde de Tantale (TaOₓ). Le dépôt de matériau 43 est typiquement suivi d'une étape de gravure anisotrope afin de retirer ce matériau 43 au fond du trou 35, ce qui peut permettre de dévoiler une ligne de routage 21 disposée au fond de ce trou 35.

On forme ensuite la deuxième électrode 47 des éléments mémoire 6 résistifs. Cette deuxième électrode 47 peut être réalisée en un matériau conducteur ou un empilement de différents matériaux conducteurs. Cette deuxième électrode 47 peut être formée par un dépôt métallique par exemple de Ti ou de TiN. La deuxième électrode 47 a typiquement une composition différente de celle de la première électrode 41 et peut être ainsi formée d'une couche (ou d'un empilement de couches) de composition différente de celle (respectivement de celui) de la deuxième électrode 47.

Ainsi, des exemples de compositions des éléments mémoire prévoient la première électrode 41, le matériau résistif 43, la deuxième électrode 47, respectivement en NiSi, HfO₂, TiN, ou respectivement en TiN, HfO₂, TiN, ou respectivement en TiN, TaOₓ, TiN.

Dans le cas où l'on réalise des éléments mémoire de type OxRAM, on prévoit de préférence une électrode réactive créatrice de lacune d'oxygène, par exemple en Ti, comme deuxième électrode 47.

Une fois les éléments mémoires réalisés, on peut former dans le trou une ligne conductrice 7 de polarisation verticale, par exemple une ligne de source SL connectée à plusieurs éléments de mémoire 6. Pour cela, on remplit le trou 35 et on comble la partie centrale du trou 35 à l'aide d'un matériau conducteur venant ainsi former une ligne conductrice 7 en contact avec la deuxième électrode 47 d'éléments mémoires répartis sur différents niveaux. Par exemple, on effectue ce remplissage à l'aide de W.

On effectue ensuite un retrait des matériaux déposés pour réaliser les éléments mémoire 6 et la ligne de polarisation dépassant de l'embouchure du ou des trous 35. Cela peut être réalisé par exemple polissage CMP (pour « chemical mechanical polishing » ou « chemical mechanical planarization »). Le masque dur ayant servi à la fabrication du ou des trous 35 est ensuite typiquement retiré.

On peut également former une ou plusieurs lignes conductrices de polarisation horizontales 5 par exemple des lignes bits communes à des transistors de commande d'un même niveau et à une même rangée de transistors de commande.

Pour cela, on peut au préalable former des tranchées 51a, 51b de part et d'autre de l'empilement de couches 26, 25₁, 26', 27,...,25₅ et longeant des faces latérales opposées de cet empilement.

Pour permettre de dévoiler des bords 56 des couches semi-conductrices 25₁, ..., 25₅, on effectue ensuite une gravure sélective du matériau sacrificiel des couches 26, 26', vis-à-vis des couches semi-conductrices 25₁, ..., 25s. et également de préférence sélective vis-à-vis des couches 27 isolantes dans cet exemple en nitrure. Des bords 56a, 56b, respectivement d'une face supérieure et d'une face inférieure des couches semi-conductrices 25₁, ..., 25₅., sont ainsi découverts.

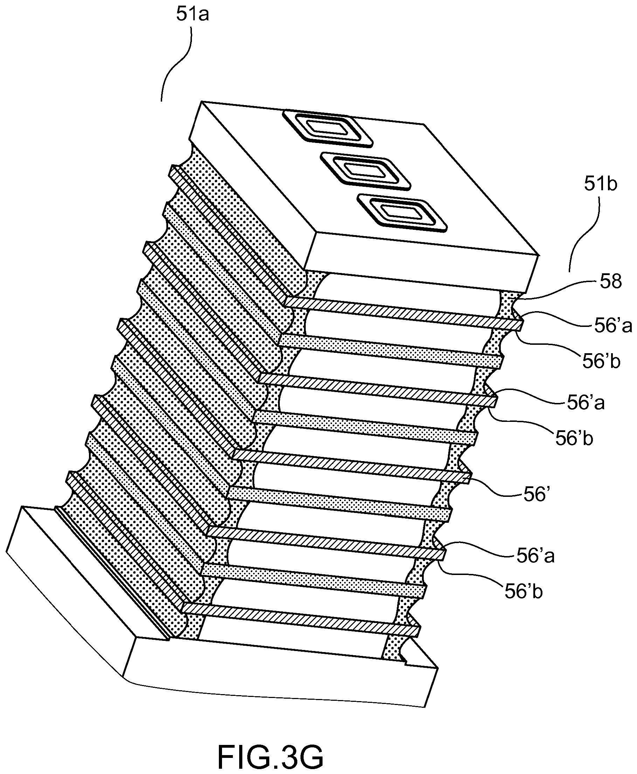

On peut ensuite (figure 3G) prévoir de recouvrir partiellement ces bords 56a, 56b par des espaceurs isolants 58 dits « internes », par exemple en SiCO, tout en laissant des régions 56'a, 56'b de la face supérieure et de la face inférieure des couches semi-conductrices 25₁, ..., 25s des couches semi-conductrices 25₁, ..., 25s dépasser.

On forme ensuite sur ces régions 56'a, 56'b dépassant de la superposition de couches, des lignes conductrices 5 horizontales. Dans l'exemple illustré ces lignes conductrices 5 sont agencées sous forme de paires de lignes 59a, 59b, qui s'étendent respectivement sur la face supérieure et sur la face inférieure des couches 25₁,..., 25s semi-conductrices.

Dans l'exemple de réalisation particulier illustré, chacune des lignes 59a, 59b de la paire peut être formée d'un empilement de matériaux avec par exemple une partie 61 siliciurée en NiSi ou en alliage de Co et de Si formée en contact avec les couches semi-conductrices et recouvertes d'un matériau métallique 62 tel que par exemple du tungstène W.

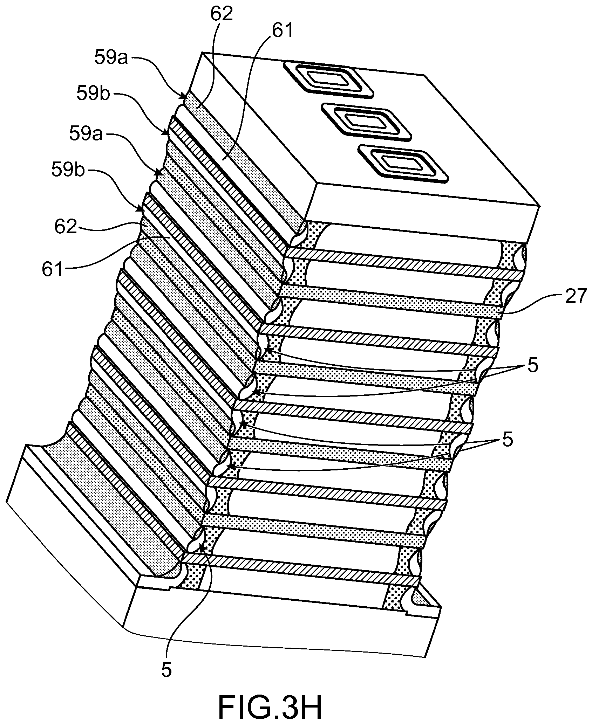

Les lignes conductrices 5 ou paires de lignes conductrices 59a, 59b sont isolées entre elles par l'intermédiaire des couches 27 isolantes inter-niveaux et peuvent former des lignes de bits BL (figure 3H).

Un matériau diélectrique d'isolation et de protection tel que par exemple du SiOCH peut être ensuite déposé dans les tranchées afin de recouvrir la superposition de lignes conductrices 59 horizontales. Un retrait de portions de ce matériau en excès et dépassant de l'embouchure des tranchées peut être alors ensuite prévu et réalisé par exemple par CMP.

La première séquence d'étapes de réalisation de la structure verticale décrites en lien avec les figures 3C à 3F et la deuxième séquences d'étapes de réalisation des lignes conductrices 5 de polarisation horizontales décrites en lien avec les figures 2G-2H peuvent, comme cela a été suggéré précédemment, être interverties.

Selon une autre variante, on peut même avantageusement mutualiser certaines étapes similaires de la première et de la deuxième séquence d'étapes.

Ainsi, la gravure sélective des couches sacrificielles 26, 26" de l'empilement conduisant à la libération de bords 56 des couches semi-conductrices 25₁,..., 25₅ peut par exemple être prévue en même temps que celle des zones 36 de ces couches 25₁,..., 25₅.

La réalisation d'espaceurs internes 38 et 58 peut être également effectuée en même temps, par dépôt d'un matériau diélectrique dans des espaces libérés par gravure des couches sacrificielles 26, 26', puis gravure de ce matériau diélectrique.

De même, on peut éventuellement mutualiser la formation des lignes conductrices 5 horizontales et celle des premières électrodes 41 des éléments mémoire, en particulier, lorsque la réalisation de ces lignes conductrices 59 et premières électrodes 51 prévoit une étape de siliciuration de formation d'alliage de métal et de semi-conducteur par exemple sur des parties des couches 25₁,..., 25₅ dévoilées par une gravure sélective des couches sacrificielles 26, 26' et qui ne sont pas recouvertes d'espaceur isolant.

Des tranchées d'isolation peuvent être formées afin de séparer l'empilement en plusieurs blocs distincts isolés entre eux.

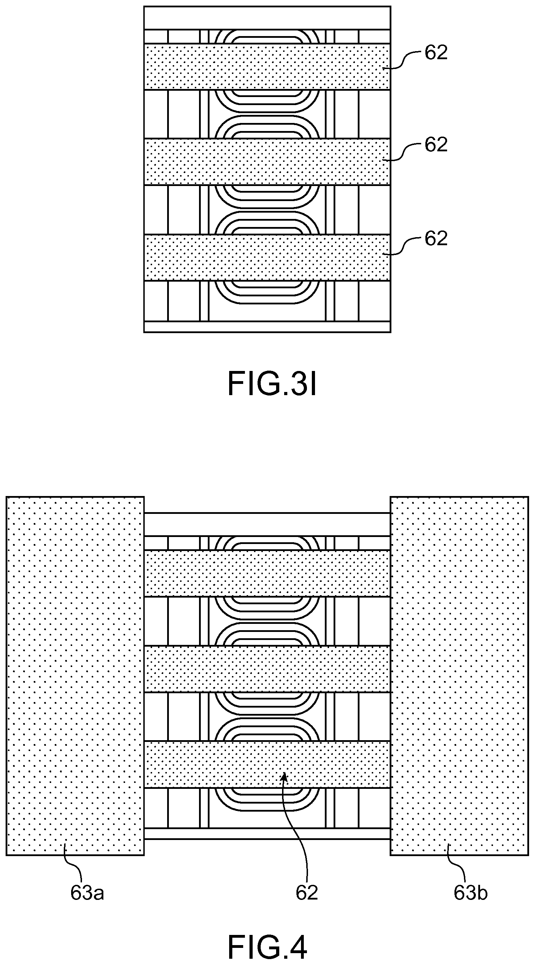

Les tranchées d'isolation sont formées typiquement à l'aide d'un procédé de gravure au cours duquel, la ou les structures verticales dont la réalisation a été décrite précédemment en lien avec les figures 3C-3F, est ou sont recouverte(s) et protégée(s) à l'aide d'un masquage 62 par exemple en résine (figure 3I).

Pour permettre également de protéger les lignes conductrices 5 horizontales, le masquage 62 peut être doté également comme sur la figure 4 par des parties 63a, 63b recouvrant des faces de l'empilement sur lesquelles les lignes conductrices 59 sont disposées.

Une fois les tranchées réalisées, on remplit celles-ci d'au moins un matériau isolant 71 tel que par exemple du SiOCN. Les tranchées d'isolation 73 ainsi réalisées permettent de séparer et d'isoler deux à deux des blocs adjacents de l'empilement chacun formés d'une superposition de couche semi-conductrices 25₁,...,25₅.

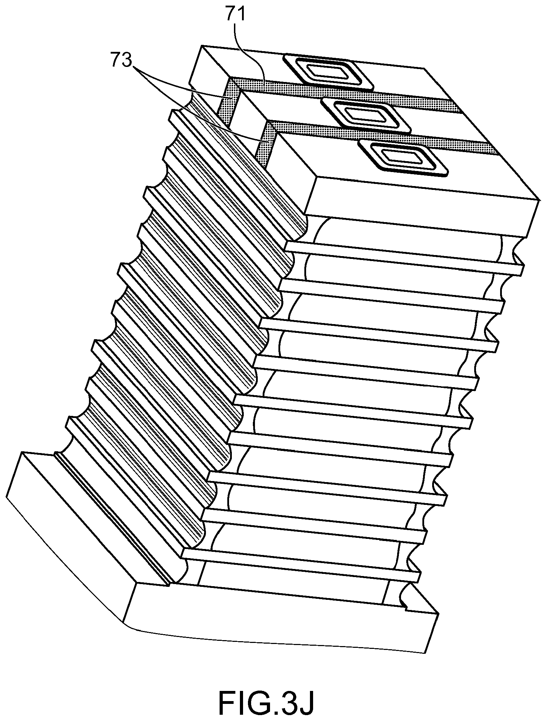

On réalise ainsi une isolation pour une superposition de transistors prévus dans un bloc donné de l'empilement et une autre superposition de transistors prévus dans un autre bloc de l'empilement adjacent audit bloc donné (figure 3J).

Pour réaliser une structure de grille pour les transistors de commande et former une ou plusieurs zones conductrices 3 de polarisation de grilles ou bien un ou plusieurs plans de mots WP, on forme à partir d'un empilement tel que décrit précédemment un masquage comportant une ou plusieurs ouvertures.

On effectue alors une gravure sélective des couches sacrificielles 26, 26' de l'empilement à travers la ou les ouvertures de ce masquage. On peut mettre en œuvre le retrait des couches sacrificielles de sorte à libérer un espace autour et dévoiler la face supérieure, la face inférieure, et des régions latérales des couches semi-conductrices 25₁,...,25₅.

Puis, on forme dans la ou les ouvertures une structure de grille, qui selon l'invention forme une double-grille s'étendant sur la face supérieure ainsi que sur la face inférieure des couches semi-conductrices 25₁,...,25₅. La structure de grille réalisée peut même être une structure de grille enrobante lorsque des régions latérales des couches semi-conductrices 25₁,...,25₅ sont également recouvertes par la structure de grille.

Selon un exemple de réalisation particulier, on peut prévoir de conférer à un empilement tel que décrit précédemment et comprenant la superposition de couches semi-conductrices 25₁, ..., 25₅ un profil en escaliers avec une pluralité de marches formant respectivement des zones de prise(s) de contact(s) . Un tel profil peut être employé en particulier pour faciliter la réalisation de contacts verticaux distincts (non représentés) sur les lignes de polarisation horizontales 5 qui peuvent être par exemple des lignes de bits. Le document US 9053 976 émanant de la Demanderesse donne des exemples de réalisation d'un tel profil en escalier. Dans une telle structure en escalier, des espaceurs isolants peuvent être prévus pour isoler les couches semi-conductrices entre elles et les lignes de polarisation entre elles.

Selon un exemple de réalisation particulier, afin de réaliser une connexion de lignes conductrices de polarisation verticales, on peut en variante ou en combinaison des lignes de routages prévues sous l'empilement, prévoir des lignes de routage horizontales disposées cette fois sur l'empilement.

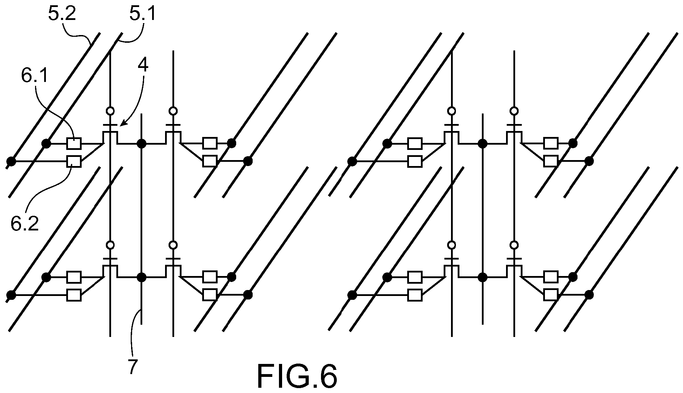

Une variante d'agencement est illustrée sur la figure 6. Pour cette variante, un même transistor de commande 4 est associé à deux éléments résistifs 6.1, 6.2, connectés respectivement à une ligne de polarisation horizontale 5.1 et une autre ligne de polarisation horizontale 5.2 distincte et qui peut ainsi acheminer un potentiel différent de celui de la ligne de polarisation 5.1. Les éléments résistifs sont connectés à une même électrode du transistor 4 de commande, lui-même doté d'une électrode connecté à une ligne de polarisation verticale 7.

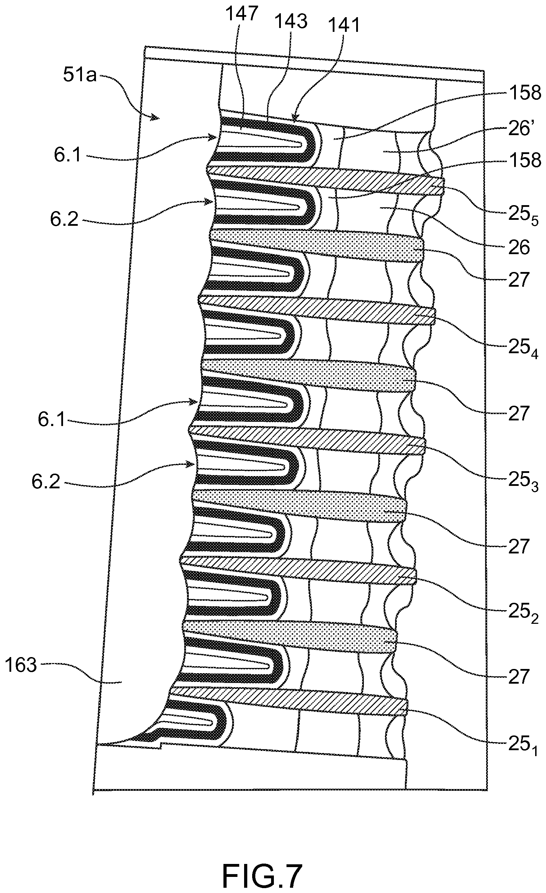

La figure 7 illustre un exemple de structure reproduisant un tel type d'agencement. Pour mettre en œuvre une telle structure, on peut partir d'un empilement tel que décrit précédemment par exemple en liaison avec la figure 3B, à travers lequel on forme une tranchée 51a traversant la superposition de couches semi-conductrices 25₁, ..., 25₅ de couches isolantes intermédiaires 27 et de couches sacrificielles 26, 26'.

On retire ensuite des portions des couches sacrificielles 26, 26' situées dans la tranchée 51a, par gravure de préférence sélective tout en préservant les couches semi-conductrices 25₁, ..., 25₅ et les couches isolantes intermédiaires 27. On libère ainsi des espaces que l'on comble partiellement par le biais de matériau isolant 158, par exemple du SiCO.

On forme ensuite dans des espaces restants un empilement mémoire comprenant au moins une couche conductrice 141 formant une première électrode 41 d'élément mémoire, une couche de matériau résistif 143 en particulier un oxyde diélectrique, et une autre couche conductrice 143, formant une deuxième électrode 43 d'élément mémoire.

L'empilement est ensuite retiré de la tranchée 51a, par exemple par gravure isotrope, afin d'isoler entre elles les électrodes respectives des différents éléments mémoires.

Puis, on remplit la tranchée d'un matériau diélectrique 163 tel que par exemple du SiOCN, afin de réaliser une isolation entre les éléments mémoires.

On peut ainsi obtenir une structure avec un transistor de commande dont la région de source ou de drain est formée dans une couche semi-conductrice donnée parmi les couches semi-conductrices 25₁, ..., 25s superposées et est connectée à la fois à un élément mémoire 6.1 agencé sur une face supérieure de cette couche semi-conductrice donnée ainsi qu'à un autre élément mémoire 6.2 agencé sur une face inférieure de cette couche semi-conductrice donnée, opposée à la dite face supérieure.

Un mode de réalisation particulier prévoir d'intégrer des cellules mémoires résistives telles que décrites précédemment dans un dispositif de mémoire associative ou de mémoire adressable par le contenu (CAM pour « Content-Addressable Memory »). Ce type de mémoire, plutôt que de permettre de sortir une donnée logique correspondant à une adresse en entrée, permet de chercher des occurrences ou la présence de mots de données ou d'informations logiques.

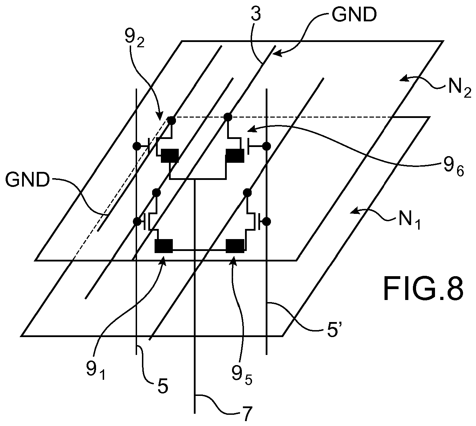

Un exemple d'agencement de cellules d'une telle mémoire CAM est donné par exemple sur la figure 8.

Les cellules 9₁, 9₂, 9₅, 9₆ peuvent avoir un agencement dans lequel une ligne de polarisation verticale 7 est commune à des cellules 9₁, 9₂, 9₅, 9₆ de niveaux différents Ni, N₂. Les cellules 9₁, 9₂, 9₅, 9₆ sont associées chacune à une ligne de polarisation horizontale 3 qui dans cet exemple peut être connectée à la masse GND.

Des cellules 9₁ et 9₂ de niveaux différents N₁, N₂ et appartenant et à une même colonne de cellules ont des transistors de commande 4 respectifs dont les grilles sont connectées à une même zone conductrice 5 destinée à recevoir un signal représentatif d'un niveau logique donné. D'autres cellules 9₅ et 9₆ respectivement du premier niveau N₁ et du deuxième niveau N₂ appartenant à une autre colonne et qui sont connectées à la même ligne de polarisation verticale, ont des transistors de commande respectifs dont les grilles sont connectées à une même autre zone conductrice 5' destinée à recevoir un signal représentatif d'un niveau logique complémentaire audit niveau logique donné appliqué sur la zone conductrice 5.

## Revendications

1. Dispositif mémoire, en particulier de mémoire adressable par le contenu (CAM), doté d'un support et de plusieurs niveaux superposés de cellules mémoires résistives (9₁, 9₂, 9₃, 9₄, 9₅, 9₆) formés sur ce support, chaque niveau (N₁ ; N₂ ;... ;) comportant une ou plusieurs rangées (x; x+1) d'une ou plusieurs cellules mémoire(s) résistive(s), chaque cellule mémoire résistive comprenant un élément mémoire (6) à résistance variable, en particulier de type PCRAM ou OxRAM, formé d'une zone de matériau de résistivité variable disposée entre une première électrode et une deuxième électrode, ledit élément mémoire (6) étant connecté à une région de source ou de drain d'un transistor de commande (4), ledit transistor de commande (4) étant formé dans une couche semi-conductrice donnée d'une superposition de couches semi-conductrices (25₁, 25₂, 25₃, 25₄, 25₅) formées sur ledit support et dans lesquelles des régions de canal respectives de transistors de commande respectifs de cellules mémoires résistives sont agencées,
**caractérisé en ce que** ledit transistor de commande a une grille qui s'étend contre une face supérieure et contre une face inférieure de ladite couche semi-conductrice donnée.

2. Dispositif mémoire selon la revendication 1, dans lequel une première colonne verticale de cellules de niveaux différents comporte une première cellule (9₁) d'un premier niveau (N₁) et une deuxième cellule (9₂) appartenant à un deuxième niveau (N₂) parmi lesdits niveaux superposés de cellules, la première cellule (9₁) et la deuxième cellule (9₂) étant dotées respectivement d'un premier transistor de commande et d'un deuxième transistor de commande, le premier transistor de commande et le deuxième transistor de commande ayant une électrode de grille (41) commune ou ayant des électrodes de grilles respectives connectées entre elles et à une même zone conductrice (3).

3. Dispositif mémoire selon la revendication 2, dans lequel ladite électrode de grille (41) commune ou lesdites électrodes de grilles (41) respectives sont reliées à une même zone conductrice (3) appelée « premier plan de mot » (WP₁), une deuxième colonne verticale de cellules comportant une troisième cellule (9₃) appartenant au premier niveau (N₁) et une quatrième cellule (9₄) appartenant au deuxième niveau (N₂) et dotées respectivement d'un troisième transistor de commande et d'un quatrième transistor de commande, le troisième transistor de commande et le quatrième transistor de commande ayant une grille connectée audit premier plan de mot (WP₁).

4. Dispositif mémoire selon la revendication 3, dans lequel la première cellule (9₁) et la troisième cellule (9₃) sont connectées à une même première ligne de polarisation horizontale (BL_{1,1}) parmi une pluralité de lignes de polarisation horizontales (BL_{1,1}, BL_{1,2}, BL_{2,2}) dans lequel la deuxième cellule (9₂) et la quatrième cellule (9₄) sont connectées à une même deuxième ligne de polarisation horizontale (BL_{1,2}) de ladite pluralité de lignes de polarisation horizontales.

5. Dispositif mémoire selon l'une des revendications 3 ou 4, dans lequel la première cellule (9₁) et la troisième cellule (9₃) sont disposées sur une même première rangée de cellules dudit premier niveau (N₁), dans lequel la deuxième cellule (9₂) et la quatrième cellule (9₄) sont disposées sur une même première rangée de cellules dudit deuxième niveau (N₂), le dispositif comprenant un autre plan de mot, distinct dudit premier plan de mot, connecté respectivement à des cellules d'une deuxième rangée de cellules dudit premier niveau et à une deuxième rangée de cellules dudit deuxième niveau.

6. Dispositif mémoire selon l'une des revendications 3 à 5, dans lequel la première cellule (9₁) et la deuxième cellule (9₂) sont connectées à une même première ligne de polarisation verticale (SL₁) parmi une pluralité de lignes de polarisation verticales (SL₁, SL_{2,...}), dans lequel la troisième cellule (9₃) et la quatrième cellule (9₄) sont connectées à une même deuxième ligne de polarisation verticale (SL₂) de ladite pluralité de lignes de polarisation verticales.

7. Dispositif mémoire selon la revendication 6, dans lequel une cinquième cellule (9₅) appartenant au premier niveau (N₁) et à une deuxième rangée de cellule(s) différente de la première rangée, et une sixième cellule (9₆) appartenant au deuxième niveau (N₂) sont connectées à ladite première ligne de polarisation verticale (SL₁).

8. Dispositif mémoire selon l'une des revendications 1 à 7, dans lequel ladite superposition de couches semi-conductrices (25₁, 25₂, 25₃, 25₄, 25₅) appartient à un empilement comprenant une ou plusieurs couches isolantes (27) disposée(s) chacune entre deux couches semi-conductrices de ladite superposition de couches semi-conductrices (25₁, 25₂, 25₃, 25₄, 25₅).

9. Dispositif mémoire selon l'une des revendications 1 à 8, dans lequel ladite région de source ou de drain dudit transistor de commande est connectée à un autre élément mémoire (6) à résistance variable formé d'une zone de matériau de résistivité variable disposée entre une première électrode et une deuxième électrode, ledit élément mémoire et ledit autre élément mémoire étant agencés respectivement sur une face supérieure et sur une face inférieure de ladite couche semi-conductrice donnée.

10. Dispositif mémoire selon l'une des revendications 1 à 9, dans lequel la source, le canal et le drain du transistor de commande présentent le même dopage.

11. Procédé de réalisation d'un dispositif mémoire selon l'une des revendications 1 à 10, le procédé comprenant au moins une étape de formation sur un support (10) d'un empilement de couches, l'empilement comprenant ladite superposition de couches semi-conductrices (25₁, 25₂, 25₃, 25₄, 25₅).

12. Procédé selon la revendication 11, dans lequel ledit empilement est formé sur une couche superficielle de matériau semi-conducteur du support, des régions de canal de transistors étant agencées dans ladite couche superficielle.

13. Procédé selon la revendication 12, dans lequel des transistors de commande sont formés au niveau des couches semi-conductrices (25₁, 25₂, 25₃, 25₄, 25₅), chaque transistor de commande comprenant un source, un canal et un drain présentant le même dopage.

14. Procédé selon l'une des revendications 11 à 13, dans lequel ledit empilement comprend une alternance de couches sacrificielles (26, 26') et de couche semi-conductrices formant ladite superposition de couches semi-conductrices (25₁, 25₂, 25₃, 25₄, 25₅), une ou plusieurs couches semi-conductrices donnée(s) de ladite superposition étant agencées chacune sur et en contact d'une première couche sacrificielle (26) et sous et en contact d'une deuxième couche sacrificielle (26').

15. Procédé selon la revendication 14, le procédé comprenant en outre, après formation de l'empilement des étapes de :
- formation d'au moins un trou (35) ou d'au moins une tranchée (51a, 51b) à travers l'empilement de sorte à dévoiler une zone de cet empilement,
- effectuer dans cette zone une gravure sélective de parties des couches sacrificielles (26,26'), de sorte à libérer un espace contre une portion (36a, 56a) d'une face supérieure de ladite ou desdites couches semi-conductrice(s) donnée(s) et à libérer un autre espace contre une portion (36b, 56b) d'une face inférieure de la ou les couches semi-conductrice donnée(s), la face inférieure étant opposée à la face supérieure,
- former des régions conductrices (59, 41, 141) sur lesdites portions.

## Patentansprüche

1. Speichervorrichtung, insbesondere mit inhaltsadressierbarem Speicher (CAM), versehen mit einem Träger und mit mehreren übereinanderliegenden Niveaus Widerstandsspeicherzellen (9₁, 9₂, 9₃, 9₄, 9₅, 9₆), die auf diesem Träger gebildet sind, wobei jedes Niveau (N₁; N₂; ...;) eine oder mehrere Reihen (x; x+1) aus einer oder mehreren Widerstandsspeicherzelle(n) aufweist, wobei jede Widerstandsspeicherzelle ein Speicherelement (6) mit variablem Widerstand, insbesondere vom Typ PCRAM oder OxRAM, umfasst, gebildet aus einen Zone aus Material mit variabler Resistivität, die zwischen einer ersten Elektrode und einer zweiten Elektrode angeordnet ist, wobei das Speicherelement (6) mit einer Quellen- oder Drainregion eines Steuertransistors (4) verknüpft ist, wobei der Steuertransistor (4) in einer gegebenen halbleitenden Schicht einer Übereinanderlagerung halbleitender Schichten (25₁, 25₂, 25₃, 25₄, 25s) gebildet ist, die auf dem Träger gebildet sind und in denen jeweilige Kanalregionen jeweiliger Steuertransistoren von Widerstandsspeicherzellen eingerichtet sind,
**dadurch gekennzeichnet, dass** der Steuertransistor ein Gitter hat, das sich an einer oberen Fläche und an einer unteren Fläche der gegebenen halbleitenden Schicht erstreckt.

2. Speichervorrichtung nach Anspruch 1, wobei eine erste vertikale Säule aus Zellen unterschiedlicher Niveaus eine erste Zelle (9₁) eines ersten Niveaus (N₁) und eine zweite Zelle (9₂) aufweist, die zu einem zweiten Niveau (N₂) der übereinanderliegenden Zellenniveaus gehört, wobei die erste Zelle (9₁) und die zweite Zelle (9₂) jeweils mit einem ersten Steuertransistor und einem zweiten Steuertransistor versehen sind, wobei der erste Steuertransistor und der zweite Steuertransistor eine gemeinsame Gitterelektrode (41) haben oder jeweilige Gitterelektroden haben, die miteinander und mit derselben leitenden Zone (3) verknüpft sind.

3. Speichervorrichtung nach Anspruch 2, wobei die gemeinsame Gitterelektrode (41) oder die jeweiligen Gitterelektroden (41) mit derselben leitenden Zone (3), bezeichnet als "erste Wortebene" (WP₁), verbunden sind, wobei eine zweite vertikale Säule Zellen eine dritte Zelle (9₃) aufweist, die zum ersten Niveau (N₁) gehört und eine vierte Zelle (9₄), die zum zweiten Niveau (N₂) gehört und jeweils mit einem dritten Steuertransistor und mit einem vierten Steuertransistor versehen sind, wobei der dritte Steuertransistor und der vierte Steuertransistor ein Gitter haben, das mit der ersten Wortebene (WP₁) verknüpft ist.

4. Speichervorrichtung nach Anspruch 3, wobei die erste Zelle (9₁) und die dritte Zelle (9₃) mit derselben ersten horizontalen Polarisationszeile (BL_{1,1}) von einer Vielzahl horizontaler Polarisationszeilen (BL_{1,1}, BL_{1,2}, BL_{2,2}) verknüpft sind, wobei die zweite Zelle (9₂) und die vierte Zelle (9₄) mit derselben zweiten horizontalen Polarisationszeile (BL_{1,2}) der Vielzahl horizontaler Polarisationszeilen verknüpft sind.

5. Speichervorrichtung nach einem der Ansprüche 3 oder 4, wobei die erste Zelle (9₁) und die dritte Zelle (9₃) auf derselben ersten Zellenreihe des ersten Niveaus (N₁) angeordnet sind, wobei die zweite Zelle (9₂) und die vierte Zelle (9₄) auf derselben ersten Zellenreihe des zweiten Niveaus (N₂) angeordnet sind, wobei die Vorrichtung eine andere Wortebene umfasst, die sich von der ersten Wortebene unterscheidet, die jeweils mit Zellen einer zweiten Reihe von Zellen des ersten Niveaus und mit einer zweiten Reihe von Zellen des zweiten Niveaus verknüpft ist.

6. Speichervorrichtung nach einem der Ansprüche 3 bis 5, wobei die erste Zelle (9₁) und die zweite Zelle (9₂) mit derselben ersten vertikalen Polarisationszeile (SL₁) einer Vielzahl vertikaler Polarisationszeilen (SL₁, SL₂, ...) verknüpft sind, wobei die dritte Zelle (9₃) und die vierte Zelle (9₄) mit derselben zweiten vertikalen Polarisationszeile (SL₂) der Vielzahl vertikaler Polarisationszeilen verknüpft sind.

7. Speichervorrichtung nach Anspruch 6, wobei eine fünfte Zelle (9s), die zum ersten Niveau (N₁) und zu einer zweiten Zellenreihe gehört, die sich von der ersten Reihe unterscheidet, und eine sechste Zelle (9₆), die zum zweiten Niveau (N₂) gehört, mit der ersten vertikalen Polarisationszeile (SL₁) verknüpft sind.

8. Speichervorrichtung nach einem der Ansprüche 1 bis 7, wobei die Übereinanderlagerung halbleitender Schichten (25₁, 25₂, 25₃, 25₄, 25s) zu einem Stapel gehört, der eine oder mehrere Isolierschichten (27) umfasst, die jeweils zwischen zwei halbleitenden Schichten der Übereinanderlagerung halbleitender Schichten (25₁, 25₂, 25₃, 25₄, 25s) angeordnet sind.

9. Speichervorrichtung nach einem der Ansprüche 1 bis 8, wobei die Quellen- oder Drainregion des Steuertransistors mit einem anderen Speicherelement (6) mit variablem Widerstand verknüpft ist, das von einer Zone aus Material mit variabler Resistivität gebildet ist, die zwischen einer ersten Elektrode und einer zweiten Elektrode angeordnet ist, wobei das Speicherelement und das andere Speicherelement jeweils auf einer oberen Fläche und auf einer unteren Fläche der gegebenen halbleitenden Schicht eingerichtet sind.

10. Speichervorrichtung nach einem der Ansprüche 1 bis 9, wobei die Quelle, der Kanal und der Drain des Steuertransistors dieselbe Dotierung aufweisen.

11. Verfahren zur Herstellung einer Speichervorrichtung nach einem der Ansprüche 1 bis 10, wobei das Verfahren mindestens einen Schritt des Bildens eines Schichtstapels auf einem Träger (10) umfasst, wobei der Stapel die Übereinanderlagerung halbleitender Schichten (25₁, 25₂, 25₃, 25₄, 25s) umfasst.

12. Verfahren nach Anspruch 11, wobei der Stapel auf einer Oberflächenschicht aus halbleitendem Material des Trägers gebildet ist, wobei Kanalregionen von Transistoren in der Oberflächenschicht eingerichtet sind.

13. Verfahren nach Anspruch 12, wobei Steuertransistoren im Bereich der halbleitenden Schichten (25₁, 25₂, 25₃, 25₄, 25s) gebildet sind, wobei jeder Steuertransistor eine Quelle, einen Kanal und einen Drain mit derselben Dotierung umfasst.

14. Verfahren nach einem der Ansprüche 11 bis 13, wobei der Stapel sich abwechselnde Opferschichten (26, 26') und halbleitende Schichten umfasst, die die Übereinanderlagerung halbleitender Schichten (25₁, 25₂, 25₃, 25₄, 25s) bilden, wobei eine oder mehrere gegebene halbleitende Schichten der Übereinanderlagerung jeweils auf und im Kontakt mit einer ersten Opferschicht (26) und unter und im Kontakt mit einer zweiten Opferschicht (26') eingerichtet sind.

15. Verfahren nach Anspruch 14, wobei das Verfahren ferner nach dem Bilden des Stapels folgende Schritte umfasst:
- Bilden von mindestens einem Loch (35) oder von mindestens einem Graben (51a, 51b) durch den Stapel, so dass eine Zone dieses Stapels freigelegt wird,
- Durchführen, in dieser Zone, einer selektiven Ätzung von Teilen der Opferschichten (26, 26'), so dass eine Stelle an einem Abschnitt (36a, 56a) einer oberen Fläche der gegebenen halbleitenden Schicht(en) freigelegt wird und eine andere Stelle an einem Abschnitt (36b, 56b) einer unteren Fläche der gegebenen halbleitenden Schicht(en) freigelegt wird, wobei die untere Fläche der oberen Fläche gegenüberliegt,
- Bilden der leitenden Regionen (59, 41, 141) auf den Abschnitten.

## Claims

1. A memory device provided with a support and several superimposed levels of resistive memory cells (9₁, 9₂, 9₃, 9₄, 9₅, 9₆) formed on this support, each level (N₁; N₂; ...;) including one or more rows (x; x+1) of one or more resistive memory cell(s), each resistive memory cell comprising a variable resistance memory element (6), in particular of the PCRAM or OxRAM type, formed of a variable resistivity material zone disposed between a first electrode and a second electrode, said memory element (6) being connected to a source or drain region of a control transistor (4), said control transistor (4) being formed into a given semi-conducting layer of a superimposition of semi-conducting layers (25₁, 25₂, 25₃, 25₄, 25₅) formed on said support and in which respective channel regions of respective control transistors of resistive memory cells are arranged,
wherein said control transistor has a gate which extends against an upper face and against a lower face of said given semi-conducting layer.

2. The memory device according to claim 1, wherein a first vertical column of cells of different levels includes a first cell (9₁) of a first level (N₁) and a second cell (9₂) belonging to a second level (N₂) from said superimposed levels of cells, the first cell (9₁) and second cell (9₂) being respectively provided with a first control transistor and second control transistor, the first control transistor and second control transistor having a common gate electrode (41) or having respective gate electrodes connected to each other and to a same conducting zone (3).

3. The memory device according to claim 2, wherein said common gate electrode (41) or said respective gate electrodes (41) are interconnected to a same conducting zone (3) called "first word plane" (WP₁), a second vertical column of cells including a third cell (9₃) belonging to the first level (N₁) and a fourth cell (9₄) belonging to the second level (N₂) and respectively provided with a third control transistor and fourth control transistor, the third control transistor and fourth control transistor having a gate connected to said first word plane (WP₁).

4. The memory device according to one of claims 2 or 3, wherein the first cell (9₁) and third cell (9₃) are connected to a same first horizontal bias line (BL_{1,1}) from a plurality of horizontal bias lines (BL_{1,1}, BL_{1,2}, BL_{2,2}) wherein the second cell (9₂) and fourth cell (9₄) are connected to a same second horizontal bias line (BL_{1,2}) of said plurality of horizontal bias lines.

5. The memory device according to one of claims 2 to 4, wherein the first cell (9₁) and third cell (9₃) are disposed on a same first row of cells of said first level (N₁), wherein the second cell (9₂) and fourth cell (9₄) are disposed on a same first row of cells of said second level (N₂), the device comprising another word plane, distinct from said first word plane, respectively connected to cells of a second row of cells of said first level and to a second row of cells of said second level.

6. The memory device according to one of claims 2 to 5, wherein the first cell (9₁) and second cell (9₂) are connected to a same first vertical bias line (SL₁) from a plurality of vertical bias lines (SL₁, SL_{2,...}), wherein the third cell (9₃) and fourth cell (9₄) are connected to a same second vertical bias line (SL₂) of said plurality of vertical bias lines.

7. The memory device according to claim 6, wherein a fifth cell (9₅) belonging to the first level (N₁) and to a second row of cell(s) different from the first row, and a sixth cell (9₆) belonging to the second level (N₂) are connected to said first vertical bias line (SL₁).

8. The memory device according to one of claims 1 to 7, wherein said superimposition of semi-conducting layers (25₁, 25₂, 25₃, 25₄, 25₅) belongs to a stack comprising one or more insulating layers (27) each disposed between two semi-conducting layers of said superimposition of semi-conducting layers (25₁, 25₂, 25₃, 25₄, 25₅).

9. The memory device according to one of claims 1 to 8, wherein said source or drain region of said control transistor connected to another variable resistance memory element (6) formed of a variable resistivity material zone disposed between a first electrode and a second electrode, said memory element and said other memory element being respectively arranged on an upper face and on a lower face of said given semi-conducting layer.

10. The memory device according to one of claims 1 to 9, wherein the source, channel and drain of the control transistor have the same doping.

11. A method for making a memory device according to one of claims 1 to 10, the method comprising at least one step of forming a stack of layers on a support (10), the stack comprising said superimposition of semi-conducting layers (25₁, 25₂, 25₃, 25₄, 25₅).

12. The method according to claim 11, wherein said stack is formed on a semiconductor material surface layer of the support, channel regions of transistors being arranged in said surface layer.

13. The method according to claim 12, wherein control transistors are formed at the semi-conducting layers (25₁, 25₂, 25₃, 25₄, 25₅), each control transistor comprising a source, a channel and a drain having the same doping.

14. The method according to one of claims 11 to 13, wherein said stack comprises alternating sacrificial layers (26, 26') and semi-conducting layers forming said superimposition of semi-conducting layers (25₁, 25₂, 25₃, 25₄, 25₅), one or more given semi-conducting layers of said superimposition being each arranged on and in contact with a first sacrificial layer (26) and under and in contact with a second sacrificial layer (26').

15. The method according to claim 14, the method further comprising, after forming the stack, steps of:
- forming at least one hole (35) or at least one trench (51a, 51b) through the stack so as to reveal a zone of this stack,
- in this zone, performing a selective etching of parts of sacrificial layers (26, 26'), so as to free a space against a portion (36a, 56a) of an upper face of said given semi-conducting layer(s) and to free another space against a portion (36b, 56b) of a lower face of the given semi-conducting layer(s), the lower face being opposite to the upper face,
- forming conducting regions (59, 41, 141) on said portions.
